# FASCICULE DE BREVET EUROPEEN

(11) **EP 2 689 421 B1**
(45) Date de publication et mention de la délivrance du brevet: **28.07.2021**
(21) Numéro de dépôt: 12710103.8
(22) Date de dépôt: 23.03.2012
(51) Int. Cl.: G11C 11/16, H01L 43/08, G11C 11/22

(54) **DISPOSITIF CONSTITUÉ DE DIFFÉRENTES COUCHES MINCES ET UTILISATION D'UN TEL DISPOSITIF**
VORRICHTUNG AUS VERSCHIEDENEN DÜNNSCHICHTEN UND VERWENDUNG EINER SOLCHEN VORRICHTUNG
DEVICE CONSISTING OF VARIOUS THIN FILMS AND USE OF SUCH A DEVICE

(30) Priorité: 23.03.2011 FR 1100874
(43) Date de publication de la demande: 29.01.2014
(73) Titulaire: THALES, 92200 Neuilly-sur-Seine (FR); Centre National de la Recherche Scientifique (C.N.R.S.), 75016 Paris (FR)
(72) Inventeur: BIBES, Manuel, F-75013 Paris (FR)
(74) Mandataire: Lavoix
(86) Numéro de dépôt international: PCT/EP2012/055242
(87) Numéro de publication internationale: WO 2012/127043

(56) Documents cités:
- WO-A1-2007/099277
- WO-A1-2010/032574
- DE-A1-102005 043 574
- US-A1- 2008 239 930
- PERTSEV N A ET AL: "Resistive switching via the converse magnetoelectric effect in ferromagnetic multilayers on ferroelectric substrates", NANOTECHNOLOGY, IOP, BRISTOL, GB, vol. 21, no. 47, 29 octobre 2010 (2010-10-29), page 475202, XP020199984, ISSN: 0957-4484, DOI: 10.1088/0957-4484/21/47/475202
- HU JIA-MIAN ET AL: "Electric-field control of strain-mediated magnetoelectric random access memory", JOURNAL OF APPLIED PHYSICS, AMERICAN INSTITUTE OF PHYSICS. NEW YORK, US, vol. 107, no. 9, 6 mai 2010 (2010-05-06), pages 93912-1-93912-10, XP012134085, ISSN: 0021-8979, DOI: 10.1063/1.3373593
- None

## Description

La présente invention concerne un dispositif, appartenant au domaine des hétérostructures de couches minces, pouvant notamment être utilisé comme élément mémoire, comme élément pour le traitement de l'information ou comme élément pour l'enregistrement magnétique.

Plus particulièrement, l'invention s'inscrit dans le cadre du stockage d'informations sous forme magnétique, comme par exemple dans les mémoires magnétiques non-volatiles à accès aléatoire (MRAMs).

Dans les MRAMs, l'information est stockée par la direction de l'aimantation d'une première couche magnétique (dite « libre ») par rapport à la direction de l'aimantation d'une seconde couche magnétique d'aimantation quasi-fixe (dite « bloquée »). Ces deux couches sont séparées par une fine couche d'un matériau non magnétique, généralement isolant, définissant ainsi une jonction tunnel magnétique. La résistance de la jonction dépend de l'alignement magnétique relatif des deux couches (parallèle ou antiparallèle), ce qui permet de lire l'information stockée.

Le développement actuel des MRAMs est entravé par la forte consommation énergétique de l'opération d'écriture au cours de laquelle la direction de l'aimantation de la couche libre est renversée, ce qui correspond à un changement de son orientation de 180 degrés.

Dans les premières générations de MRAMs, cette opération d'écriture était réalisée via la génération d'un champ magnétique par des lignes de courant situées à proximité de la couche libre.

Dans la seconde génération, actuellement utilisée, l'écriture est réalisée grâce au phénomène de transfert de spin via l'application d'un fort courant entre les deux couches magnétiques, à travers la fine couche isolante. Même si cette nouvelle approche a permis de réduire la puissance d'écriture de plusieurs ordres de grandeur, celle-ci vaut toujours environ 100 pJ/bit, une valeur très supérieure aux puissances d'écriture des autres technologies de mémoires non-volatiles, qui sont de l'ordre de 0,1 pJ/bit pour les mémoires Flash, 0,03 pJ/bit pour les RAMs ferroélectriques (FeRAM) et 1 pJ/bit pour les mémoires à changement de phase.

Afin de résoudre les problèmes mentionnés ci-dessus, il a été proposé de contrôler l'aimantation par un champ électrique via l'exploitation du couplage magnétoélectrique existant dans des systèmes qui combinent propriétés diélectriques, piézoélectriques et/ou ferroélectriques, et propriétés magnétiques.

En particulier, dans le cas de systèmes combinant propriétés ferroélectriques et propriétés ferromagnétiques, il apparaît possible de contrôler électriquement et de façon non-volatile les propriétés magnétiques, grâce au caractère non-volatile des matériaux ferroélectriques.

Dans cette nouvelle voie, le champ électrique est appliqué à travers un isolant (généralement le composé diélectrique, piézoélectrique et/ou ferroélectrique), et, donc, le courant associé est très faible. Il en résulte que la puissance associée à la manipulation des propriétés magnétiques via l'exploitation du couplage magnétoélectrique est très faible.

Le problème principal de ce type d'approches, exploitant le couplage magnétoélectrique, est qu'elles ne permettent pas, à l'heure actuelle, de renverser l'aimantation d'une couche ferromagnétique de façon réversible, reproductible et sans champ magnétique appliqué. Au mieux, une rotation de 90 degrés est possible, ce qui est insuffisant.

Actuellement, on distingue trois solutions visant à permettre le contrôle non-volatile d'une aimantation par un champ électrique, sans champ magnétique appliqué.

Une première approche allie la piézoélectricité et la magnétostriction. Cette approche ne permet un contrôle non-volatile que si le matériau piézoélectrique employé est également ferroélectrique. Cette solution combine classiquement un élément piézoélectrique et un élément ferromagnétique. Sous l'application d'un champ électrique à travers l'élément piézoélectrique, ce dernier se déforme (effet piézoélectrique inverse). Cette déformation se transmet à l'élément ferromagnétique, ce qui modifie son énergie d'anisotropie magnétoélastique. Il en résulte potentiellement un changement de l'axe de facile aimantation, et donc une rotation de l'aimantation, au maximum de 90 degrés.

Pertsev, N.A.; Kohlstedt, H.; Nanotechnology, vol. 21, no. 47, page 475202 (2010), décrit un dispositif comportant deux couches ferromagnétiques couplées magnétiquement, séparées par une couche mince non magnétique. Le contrôle de la direction de l'aimantation de la couche ferromagnétique inférieure est mis en oeuvre en utilisant l'effet piézoélectrique dans une couche ferroélectrique.

Dans la seconde approche, la densité de porteurs dans un élément ferromagnétique adjacent à un élément ferroélectrique est contrôlée de façon rémanente par la direction de la polarisation dans l'élément ferroélectrique, ce qui engendre un effet champ électrique.

En effet, dans les conducteurs ferromagnétiques, plusieurs propriétés magnétiques dépendent de la densité de porteurs, comme la température de Curie ou l'anisotropie magnétocristalline. Avec ce type d'approche, on peut donc modifier de façon rémanente la température de Curie et/ou la direction de l'axe de facile aimantation. Toutefois, comme dans le cas de la première approche, cela ne permet qu'une rotation de l'aimantation d'au maximum de 90 degrés.

Une troisième approche est liée au contrôle de l'interaction d'échange à l'interface présente entre un matériau multiferroïque (simultanément magnétique et ferroélectrique) et un élément ferromagnétique. S'il existe un couplage magnétoélectrique au sein du multiferroïque, permettant de contrôler ses propriétés magnétiques par un champ électrique, et un couplage d'échange entre le multiferroïque et l'élément ferromagnétique, l'application d'un champ électrique à travers le multiferroïque peut permettre de contrôler les propriétés magnétiques de l'élément ferromagnétique, et notamment la direction de l'aimantation. Ainsi, une rotation de 180 degrés est a priori possible.

WO 2010/032574 décrit un élément de mémoire magnétique comprenant une couche multiferroïque adjacente à une couche d'enregistrement magnétique. Le contrôle de l'aimantation de la couche d'enregistrement est effectué par l'application d'un champ électrique à la couche multiferroïque.

Cette approche serait probablement très efficace dans un système utilisant un matériau multiferroïque à la fois ferromagnétique et ferroélectrique. Toutefois, ce type de composé est extrêmement rare et, actuellement, il n'existe qu'à basse température. Très peu de matériaux, notamment BiFeO₃, sont multiferroïques à température ambiante, et tous ceux-ci sont antiferromagnétiques. Cela complexifie énormément le contrôle du couplage d'échange entre le multiferroïque et le ferromagnétique. Malgré d'importants efforts de recherche, cette approche n'a pas permis de contrôler de façon réversible le renversement d'une couche ferromagnétique par application d'un champ électrique à température ambiante.

L'invention a pour but de proposer un dispositif permettant de renverser, c'est dire de changer son orientation de 180 degrés, électriquement l'aimantation d'une couche ferromagnétique de façon réversible, reproductible et sans champ magnétique appliqué.

A cet effet, l'invention a pour objet un dispositif comprenant :
- un ensemble constitué de deux couches minces, respectivement supérieure et inférieure, formant chacune un élément ferromagnétique et séparées par une couche mince formant un élément non-magnétique, ledit ensemble étant constitué de façon à ce que les couches formant les éléments ferromagnétiques soient couplées magnétiquement à travers la couche formant un élément non-magnétique ;
- une électrode,
- une couche formant un élément ferroélectrique dans lequel la polarisation peut être orientée selon plusieurs directions par l'application d'une tension électrique à travers ladite couche, ladite couche formant un élément ferroélectrique étant disposée entre la couche formant un élément ferromagnétique inférieure et l'électrode ;
une épaisseur de la couche mince formant un élément non-magnétique étant choisie de façon que les couches formant les éléments ferromagnétiques soient couplées magnétiquement via l'interaction de Ruderman-Kittel-Kasuya-Yosida (RKKY) ; le dispositif étant configuré de façon à permettre un contrôle de la configuration magnétique des couches formant des éléments ferromagnétiques par la direction de la polarisation dans la couche formant un élément ferroélectrique, la direction de polarisation de la couche formant un élément ferroélectrique contrôlant la configuration magnétique des couches formant des éléments ferromagnétiques par contrôle de la période et/ou la phase de l'interaction RKKY ;
les couches formant les éléments ferromagnétiques étant couplées soit ferromagnétiquement, soit antiferromagnétiquement.

Le dispositif selon l'invention peut comporter une ou plusieurs des caractéristiques suivantes :
- la couche formant un élément non-magnétique peut posséder une épaisseur comprise entre 0,2 et 10 nm ;
- la couche formant un élément ferroélectrique peut posséder une épaisseur comprise entre 0,2 et 500 nm ;
- le dispositif peut comprendre un système permettant de fixer l'aimantation d'un des éléments ferromagnétiques dudit dispositif ;
- le système peut être constitué d'une couche formée d'un matériau antiferromagnétique ;
- l'électrode peut être formée d'un matériau ferromagnétique ; la couche formant un élément ferroélectrique peut être adaptée pour laisser passer un courant tunnel entre l'électrode ferromagnétique et la couche formant un élément ferromagnétique inférieure, ladite couche possédant de préférence une épaisseur comprise entre 0,2 et 10 nm ; ledit système permettant de fixer l'aimantation d'un des éléments ferromagnétiques dudit dispositif pouvant être adapté pour fixer l'aimantation de la couche formant un élément ferromagnétique supérieure et celle de l'électrode ferromagnétique ;
- la couche formant un élément non-magnétique peut être conductrice, ledit dispositif étant adapté pour générer un champ magnétique dipolaire dépendant de la configuration magnétique des couches formant des éléments ferromagnétiques inférieure et supérieure et pouvant être combiné sous forme de lignes ou de réseaux pour permettre la génération et le contrôle électrique d'un paysage de champ magnétique.

L'invention concerne également l'utilisation d'un dispositif selon l'invention, dans une mémoire magnétique à trois bornes dans laquelle l'information magnétique est écrite par l'application d'un champ électrique appliqué à travers l'élément ferroélectrique.

L'invention concerne également l'utilisation d'un dispositif selon l'invention, dans une mémoire magnétique à deux bornes dans laquelle l'information magnétique est écrite par l'application d'un champ électrique appliqué à travers l'élément ferroélectrique.

L'invention concerne également l'utilisation d'un dispositif selon l'invention, dans un système adapté pour l'enregistrement magnétique.

L'invention sera mieux comprise à la lecture de la description qui va suivre, donnée uniquement à titre d'exemple et faite en se référant aux dessins annexés, sur lesquels :
- la Figure 1 est une vue en coupe transversale d'un dispositif selon l'invention ;
- la Figure 2 est une vue en coupe transversale appartenant à une première structure utilisant le dispositif représenté à la Figure 1 ;
- La Figure 3 représente deux états possibles de la mémoire de la structure de la Figure 2 ;
- la Figure 4 est une vue en coupe transversale appartenant à une seconde structure utilisant le dispositif représenté à la Figure 1 ;
- La Figure 5 représente deux états possibles de la mémoire de la structure de la Figure 4 ;
- la Figure 6 est une vue en coupe transversale appartenant à une troisième structure utilisant le dispositif représenté à la Figure 1 ;
- La Figure 7 représente deux états possibles de la configuration magnétique de la structure de la Figure 6.

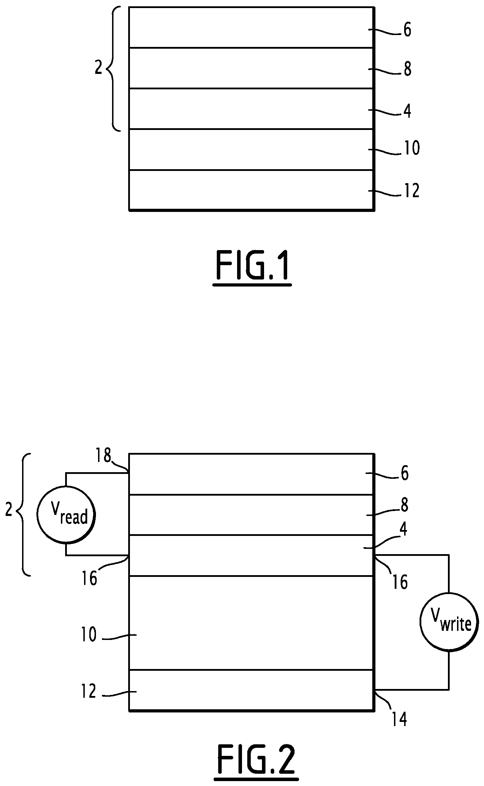

Le dispositif représenté à la Figure 1 comporte un ensemble 2 composé de deux couches minces 4, 6 formées chacune d'un matériau ferromagnétique formant un élément ferromagnétique, ledit matériau ferromagnétique étant conducteur et séparées par une couche mince 8 formée d'un matériau non-magnétique formant un élément non-magnétique.

Cet ensemble 2 est disposé sur une couche mince 10 formée d'un matériau ferroélectrique et formant un élément ferroélectrique 10, ladite couche ferroélectrique 10 étant disposée à proximité de la couche ferromagnétique 4, dite « inférieure », par opposition à la couche ferromagnétique 6, dite « supérieure ». Sous la couche mince 10, une électrode inférieure 12 permettant l'orientation de la polarisation du matériau ferroélectrique dans un sens ou dans l'autre est disposée.

Ainsi, la couche ferroélectrique 10 est disposée entre la couche ferromagnétique inférieure 4 et l'électrode 12.

Les matériaux composants les couches minces 4, 6 peuvent être identiques ou différents, des exemples de ces matériaux seront donnés dans la suite de la description.

Dans un matériau ferroélectrique, la polarisation est rémanente, c'est-à-dire qu'elle subsiste même lorsque le champ électrique ayant établi la polarisation disparait. Par application d'un champ électrique opposé et suffisamment intense, la polarisation peut être renversée et une polarisation rémanente d'orientation opposée être stabilisée. Cette opération, qui correspond au processus d'écriture d'un élément de mémoire FeRAM, est très peu consommatrice d'énergie. Ainsi, pour une FeRAM l'énergie d'écriture est de l'ordre de 0.03 pJ/bit.

Du fait qu'une couche conductrice, la couche inférieure 4, est en contact avec la couche ferroélectrique 10, la densité de porteurs de charge dans la couche conductrice est modifiée selon la direction de la polarisation dans l'élément ferroélectrique. Ainsi, la densité de porteurs peut être modifiée de façon rémanente, par application d'un champ électrique à travers l'élément ferroélectrique. Cette modification de densité correspond soit à une augmentation, soit à une diminution, selon la direction de la polarisation et le type de porteurs, électrons ou trous.

Par ailleurs, il est établi que l'aimantation d'un élément ferromagnétique adjacent à un élément ferroélectrique peut dépendre de la direction de la polarisation dans l'élément ferroélectrique [C.G. Duan et al, Phys. Rev. Lett. 97, 047201 (2006)].

L'épaisseur de la couche 8 non-magnétique est choisie de façon que les deux couches 4, 6 ferromagnétiques soient couplées magnétiquement via l'interaction de Ruderman-Kittel-Kasuya-Yosida (RKKY) [M.A. Ruderman & C. Kittel, Phys. Rev. 96, 99 (1954) ; T. Kasuya, Prog. Theor. Phys. 16, 45 (1956) ; K. Yosida, Physical Review 106, 893 (1957)].

Ainsi, de préférence, les couches ferromagnétiques 4, 6 peuvent posséder une épaisseur comprise entre 0,2 et 50 nm, et de préférence entre 0,2 et 5 nm ; la couche non-magnétique 8 peut posséder une épaisseur comprise entre 0,2 et 10 nm, et de préférence entre 0,2et 5 nm ; la couche ferroélectrique 10 peut posséder une épaisseur comprise entre 0,2 et 500 nm, et de préférence entre 0,4 et 200 nm; et l'électrode 12 peut posséder une épaisseur comprise entre 1 et 200 nm et de préférence entre 2 et 50 nm.

La nature du couplage, ferromagnétique ou antiferromagnétique, dépend de l'épaisseur de la couche 8 non-magnétique selon une fonction oscillante (voir par exemple K.B. Hathaway, « Ultrathin magnetic structures II», Springer-Verlag). La période des oscillations dépend elle-même de la structure électronique des matériaux en présence, ici les couches 4, 6 ferromagnétiques et la couche 8 non-magnétique, à travers leur vecteur d'onde de Fermi, auquel est liée la densité de porteurs. La phase de l'oscillation dépend de l'aimantation des couches 4, 6 ferromagnétiques.

En combinant, la couche ferroélectrique 10 et l'ensemble 2, il est donc possible en appliquant un champ électrique à travers la couche ferroélectrique 10, et pour une épaisseur de la couche non-magnétique 8 judicieusement choisie, de contrôler la configuration magnétique des deux couches 4, 6 ferromagnétiques et d'orienter leurs aimantations selon la même direction (cas d'un couplage ferromagnétique) ou selon des directions opposées (cas d'un couplage antiferromagnétique).

Ainsi, si l'aimantation de l'une des couches 4 ou 6 ferromagnétiques est bloquée, l'aimantation de la seconde couche pourra être renversée de façon réversible et reproductible par application d'un champ électrique.

Ainsi, la chaîne de mécanismes physiques responsable de l'effet peut se résumer comme suit :
- l'application d'un champ électrique contrôle l'orientation de la polarisation de la couche ferroélectrique 10 ;
- la polarisation de la couche ferroélectrique 10 contrôle la densité de porteurs et/ou la valeur de l'aimantation dans la couche ferromagnétique 4 adjacente ;
- la densité de porteurs dans la couche magnétique 4, adjacente à la couche ferroélectrique 10, contrôle la période et/ou la phase de l'interaction RKKY en fonction de l'épaisseur de la couche non-magnétique 8 et/ou de la valeur de l'aimantation dans la couche ferromagnétique 4 ;
- la période et/ou la phase de l'interaction RKKY contrôle la nature du couplage (ferromagnétique/antiferromagnétique) entre les deux couches ferromagnétiques 4 et 6 ;
- la nature du couplage entre les deux couches ferromagnétique 4 et 6 contrôle la direction de leurs aimantations.

A noter que ceci signifie notamment que le couplage magnétique entre la couche inférieure formant l'élément ferromagnétique inférieur 4 et la couche formant un élément ferroélectrique 10 n'est pas influencé par la direction de la polarisation dans la couche formant un élément ferroélectrique 10, c'est-à-dire que le contrôle du couplage entre les deux couches ferromagnétiques 4, 6 n'est pas réalisé au moyen du couplage magnétique entre l'élément ferromagnétique 10 et l'élément ferromagnétique inférieur 4.

Comme le mécanisme proposé dans la présente invention contrôle le signe d'un couplage magnétique (antiferromagnétique ou ferromagnétique) et non la valeur d'une anisotropie, il est possible d'induire électriquement un renversement complet de l'aimantation et non une simple rotation de 90 degrés comme dans les dispositifs de l'art antérieur.

Afin de permettre le renversement de l'aimantation de l'une des deux couches ferromagnétiques 4 ou 6, il est nécessaire de bloquer l'aimantation de la couche supérieure 6 de l'ensemble 2, opposée à la couche ferroélectrique 10. Cela peut-être réalisé de plusieurs façons. Il est, par exemple, possible de donner une forme particulière aux éléments magnétiques 4 et 6 afin de favoriser fortement une direction préférentielle de l'aimantation pour l'une des couches par rapport à l'autre, par exemple ces éléments magnétiques 4 et 6 peuvent prendre la forme d'un parallélépipède plat et très allongé. Une autre solution consiste à coupler la couche supérieure 6 ferromagnétique à un matériau antiferromagnétique. Cet exemple de réalisation sera décrit ultérieurement.

Nous allons maintenant décrire des exemples de structure exploitant des dispositifs selon l'invention, et mettant en œuvre les mécanismes physiques décrits ci-dessus.

Le premier exemple représenté à la Figure 2 est une mémoire magnétique à écriture électrique à trois bornes.

Dans cet exemple, la couche non-magnétique 8 peut être isolante et constituer alors une barrière tunnel. L'ensemble 2, composé de deux couches minces 4, 6 formées chacune d'un matériau ferromagnétique et séparées par une couche mince 8 formée d'un matériau non-magnétique, constitue donc une jonction tunnel magnétique.

Cette structure comprend trois bornes électriques, une première 14 sur l'électrode inférieure 12, une deuxième 16 sur la couche ferromagnétique inférieure 4, et une troisième 18 sur la couche ferromagnétique supérieure 6.

L'information est stockée par la configuration magnétique des couches ferromagnétiques, ces dernières pouvant être parallèles ou antiparallèles.

L'information est écrite par l'application d'une tension électrique « Vwrite » entre l'électrode inférieure 12 et la couche ferromagnétique inférieure 4.

L'information est lue par application d'une tension électrique « Vread » entre les deux couches ferromagnétique 4 et 6, et lecture du courant associé, qui dépend de la configuration magnétique de ces couches.

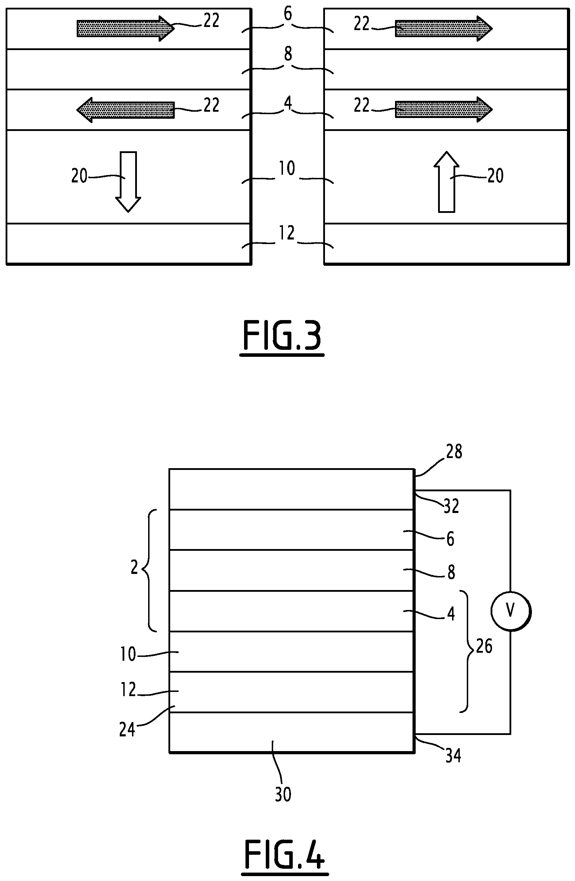

A la Figure 3, sont représentés deux états possibles de la mémoire, les flèches blanches 20 représentant la polarisation électrique de l'élément ferroélectrique 10 et les flèches noires 22 représentant l'aimantation des éléments ferromagnétiques 4 et 6.

Le second exemple représenté à la Figure 4 est une mémoire magnétique à écriture électrique à deux bornes.

Cet exemple est constitué d'un dispositif selon l'invention comprenant un ensemble 2 composé de deux couches minces 4, 6 formées chacune d'un matériau ferromagnétique et séparées par une couche mince 8 formée d'un matériau non-magnétique, la couche ferroélectrique 10 et l'électrode inférieure 12. Dans cet exemple, l'électrode inférieure 12 est formée d'un matériau ferromagnétique 24.

La couche ferroélectrique 10 est fine, elle présente de préférence une épaisseur comprise entre 0,2 et 10 nm. La couche ferroélectrique 10 joue le rôle d'une barrière tunnel et permet ainsi le passage du courant entre la couche ferromagnétique inférieure 4 et la couche ferromagnétique 24 constituant l'électrode inférieure 12.

La couche non-magnétique 8 peut être un métal ou un isolant, et posséder alors également le rôle d'une barrière tunnel.

Pour le bon fonctionnement de cette structure, la résistance de l'ensemble 2 doit être très inférieure à la résistance de l'ensemble 26 constitué par la couche ferromagnétique inférieure 4, la couche ferroélectrique 10 et la couche ferromagnétique 24.

De même, les directions de l'aimantation de la couche ferromagnétique supérieure 6 et de la couche ferromagnétique 24 constituant l'électrode inférieure 12 doivent être fixes, de sorte que l'aimantation de la couche ferromagnétique inférieure 4 puisse être renversée en renversant la polarisation du composé ferroélectrique 10 par application d'un champ électrique à travers ce composé. Afin que cette condition soit remplie, tel que représenté à la Figure 4, on intègre à la structure un système permettant de fixer l'aimantation de ces couches.

Ce système comprend un élément antiferromagnétique conducteur 28 adjacent à la couche ferromagnétique supérieure 6 et un élément antiferromagnétique conducteur 30 adjacent à la couche ferromagnétique 24 constituant l'électrode inférieure 12.

Ces éléments antiferromagnétiques conducteurs 28, 30 peuvent être soit une couche d'un conducteur antiferromagnétique, soit un système antiferromagnétique artificiel, soit un ensemble multicouche combinant ces deux types d'éléments.

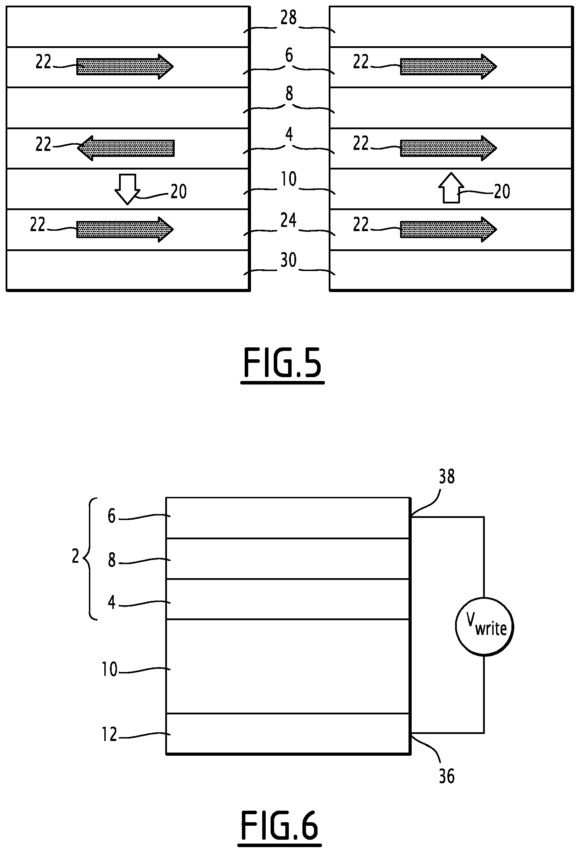

De plus, la structure comprend deux bornes électriques, une première 32 connectant la couche ferromagnétique supérieure 6 et une seconde 34 connectant la couche ferromagnétique 24. En variante, comme représenté à la Figure 5, les bornes électriques peuvent être connectées via les éléments antiferromagnétiques conducteurs 28 et 30.

Comme montré à la Figure 5, l'information est stockée par la direction de l'aimantation de la couche ferromagnétique inférieure 4.

L'information est écrite par application d'une tension électrique entre les bornes 32 et 34. Typiquement quelques volts sont suffisants car ils correspondent aux tensions nécessaires pour renverser la polarisation présente dans l'élément ferroélectrique.

L'information est lue par application d'une tension plus faible entre les bornes 32 et 34, ne modifiant pas la direction de la polarisation dans l'élément ferroélectrique 10, et par lecture du courant associé, qui dépend de la configuration magnétique dans les couches 4 et 24.

A la Figure 5 sont représentés deux états possibles de la mémoire différents par les directions 20 de la polarisation électrique et les directions 22 de l'aimantation dans les différentes couches 4, 6, 10 et 24.

Le troisième exemple représenté à la Figure 6 est un générateur de champ magnétique miniature contrôlable électriquement.

Cet exemple est constitué d'un dispositif selon l'invention comprenant un ensemble 2 composé de deux couches minces 4, 6 formées chacune d'un matériau ferromagnétique et séparées par une couche mince 8 formée d'un matériau non-magnétique, la couche ferroélectrique 10 et l'électrode inférieure 12. Dans cet exemple de réalisation, la couche non-magnétique 8 est conductrice.

De préférence, la couche ferroélectrique 10 possède une épaisseur comprise entre 0,4 et 200 nm.

La structure comprend deux bornes électriques, une première 36 connectant l'électrode inférieure 12 et une seconde 38 connectant la couche ferromagnétique supérieure 6.

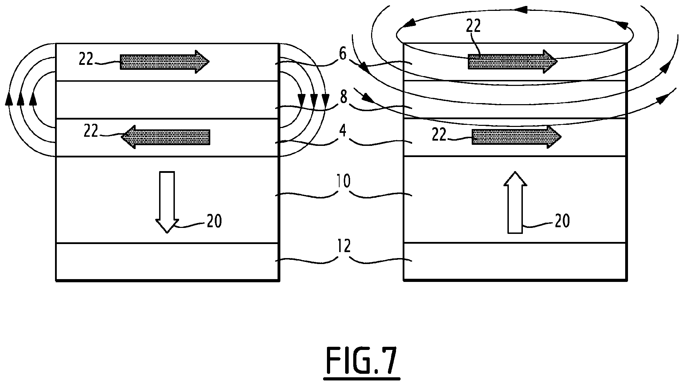

Comme montré à la Figure 7, les couches ferromagnétiques 4, 6 rayonnent un champ magnétique dipolaire et différent selon que les aimantations de ces couches sont dans une configuration parallèle, c'est-à-dire dans laquelle les directions 22 de l'aimantation sont dirigées dans la même direction, ou antiparallèle, c'est-à-dire dans laquelle les directions 22 de l'aimantation sont dirigées dans des directions opposées.

Le contrôle de la configuration magnétique par application d'un champ électrique permet donc de contrôler électriquement le champ magnétique dipolaire rayonné à proximité de la structure.

En organisant des structures telles que celle schématisée à la Figure 7 sous forme de lignes ou de réseaux, il est possible de générer à volonté par voie électrique un paysage de champ magnétique avec une résolution spatiale proche de la taille des structures.

Selon la direction de la polarisation dans le matériau ferroélectrique, la configuration magnétique des couches ferromagnétiques 4, 6 est différente ce qui modifie le champ magnétique rayonné à proximité.

Il est ainsi possible d'utiliser une telle structure comme têtes d'écriture multibits dans des systèmes d'enregistrement magnétique de l'information (disques durs ou autres).

Les éléments ferromagnétiques appartenant à l'ensemble 2 peuvent être des métaux ferromagnétiques (Co, Fe, Ni) ou leurs alliages, ou des alliages de ces métaux avec d'autres éléments 3d (Cr, Ni, Mn, etc), 4d (Ru, Pd, etc), 5d (Ir, Pt, etc) ou des terres rares (Gd, Tb, Dy, etc), des oxydes ferromagnétiques (comme SrRuO₃ ou (La,Sr)MnO₃) ou des semi-conducteurs magnétiques (III-V dopés comme Mn-GaAs, Mn-Ge, etc).

L'élément non-magnétique formant la couche mince 8 de l'ensemble 2 peut être un métal (Cu, Pt, Au, Cr, etc), un semi-conducteur (GaAs, Si, etc) ou un isolant (SrTiO₃, MgO, etc).

La couche ferroélectrique 10 peut être constituée d'un matériau ferroélectrique inorganique (BaTiO₃, Pb(Zr,Ti)O₃, BiFeO₃, SBT , SBN, etc) ou organique (PVDF, acide croconique, etc).

L'électrode inférieure 12 peut être constituée d'un métal ou d'un semi-conducteur appartenant à différentes familles, par exemple des métaux simples comme l'Au, le Ru ou le Pt, des oxydes métalliques comme le SrRuO₃ ou le (La,Sr)MnO₃, des semi-conducteurs comme le Si, le GaAs ou d'autres composés III-V, des oxydes semi-conducteurs comme ZnO, ITO ou SrTiO₃, ou des conducteurs organiques ; ils pourront être de type n ou de type p.

L'élément antiferromagnétique permettant de fixer l'aimantation d'une couche ferromagnétique peut être un métal (IrMn, PtMn, etc), un isolant (CoO, NiO, LaFeO₃, BiFeO₃, etc). Il peut également s'agir d'un élément antiferromagnétique artificiel composé d'une couche ferromagnétique, d'une couche non-magnétique et d'une couche ferromagnétique.

De façon classique, le dispositif représenté à la Figure 1 peut être élaboré par une ou plusieurs techniques de croissance combinées, telles que l'ablation laser puisée, la pulvérisation cathodique, la CVD, l'évaporation ou autres.

Ainsi, le dispositif selon l'invention combine un élément ferroélectrique et un dispositif magnétique afin de contrôler électriquement et de façon non-volatile la configuration magnétique (parallèle/antiparallèle) des éléments ferromagnétiques du dispositif.

Le dispositif selon l'invention permet de contrôler le couplage d'échange RKKY entre les couches ferromagnétiques 4 et 6, via la couche non-magnétique 8, par la polarisation d'un matériau ferroélectrique 10. Ce contrôle ferroélectrique du couplage d'échange permet de façon robuste, réversible et non-volatile de piloter l'alignement relatif des aimantations des deux couches ferromagnétiques de l'ensemble 2.

Avantageusement, en bloquant magnétiquement l'aimantation d'une des deux couches ferromagnétiques, la direction de l'aimantation de l'autre couche peut ainsi être pilotée.

Grâce au dispositif de l'invention, l'aimantation d'une couche ferromagnétique peut être renversée de façon réversible, reproductible, sans champ magnétique, tout en ne nécessitant qu'une consommation d'énergie relativement faible.

## Revendications

1. Dispositif comprenant :
- un ensemble (2) constitué de deux couches minces, respectivement supérieure (6) et inférieure (4), formant chacune un élément ferromagnétique et séparées par une couche mince (8) formant un élément non-magnétique, ledit ensemble étant constitué de façon à ce que les couches formant les éléments ferromagnétiques (4, 6) soient couplées magnétiquement à travers la couche formant un élément non-magnétique (8) ;
- une électrode (12),
- une couche formant un élément ferroélectrique (10) dans lequel la polarisation peut être orientée selon plusieurs directions par l'application d'une tension électrique à travers ladite couche, ladite couche formant un élément ferroélectrique (10) étant disposée entre la couche formant un élément ferromagnétique inférieure (4) et l'électrode (12) ;
une épaisseur de la couche mince (8) formant un élément non-magnétique étant choisie de façon que les couches formant les éléments ferromagnétiques (4, 6) soient couplées magnétiquement via l'interaction de Ruderman-Kittel-Kasuya-Yosida, RKKY ; ledit dispositif étant configuré de façon à permettre un contrôle de la configuration magnétique des couches formant des éléments ferromagnétiques (4, 6) par la direction de la polarisation dans la couche formant un élément ferroélectrique (10), la direction de polarisation de la couche formant un élément ferroélectrique (10) contrôlant la configuration magnétique des couches formant des éléments ferromagnétiques (4, 6) par contrôle de la période et/ou la phase de l'interaction RKKY ;
les couches formant les éléments ferromagnétiques (4, 6) étant couplées soit ferromagnétiquement, soit antiferromagnétiquement.

2. Dispositif selon la revendication 1, **caractérisé en ce que** la couche formant un élément non-magnétique (8) possède une épaisseur comprise entre 0,2 et 10 nm.

3. Dispositif selon la revendication 1 ou 2, **caractérisé en ce que** la couche formant un élément ferroélectrique (10) possède une épaisseur comprise entre 0,2 et 500 nm.

4. Dispositif selon l'une quelconque des revendications 1 à 3, **caractérisé en ce qu'**il comprend un système permettant de fixer l'aimantation d'un des éléments ferromagnétiques dudit dispositif.

5. Dispositif selon la revendication 4, **caractérisé en ce que** ledit système est constitué d'une couche (28, 30) formée d'un matériau antiferromagnétique.

6. Dispositif selon la revendication 4 ou 5, dans lequel :
- l'électrode (12) est formée d'un matériau ferromagnétique (24) ;
- la couche formant un élément ferroélectrique (10) est adaptée pour laisser passer un courant tunnel entre l'électrode ferromagnétique (24) et la couche formant un élément ferromagnétique inférieure (4), ladite couche possédant de préférence une épaisseur comprise entre 0,2 et 10 nm ;
- ledit système permettant de fixer l'aimantation d'un des éléments ferromagnétiques est adapté pour fixer l'aimantation de la couche formant un élément ferromagnétique supérieure (6) et celle de l'électrode ferromagnétique (24).

7. Dispositif selon l'une quelconque des revendications 1 à 3, **caractérisé en ce que** la couche formant un élément non-magnétique (8) est conductrice, ledit dispositif étant adapté pour générer un champ magnétique dipolaire dépendant de la configuration magnétique des couches formant des éléments ferromagnétiques inférieure (4) et supérieure (6) et pouvant être combiné sous forme de lignes ou de réseaux pour permettre la génération et le contrôle électrique d'un paysage de champ magnétique.

8. Utilisation d'un dispositif selon l'une quelconque des revendications 1 à 5, dans une mémoire magnétique à trois bornes dans laquelle l'information magnétique est écrite par l'application d'un champ électrique appliqué à travers l'élément ferroélectrique (10).

9. Utilisation d'un dispositif selon la revendication 6, dans une mémoire magnétique à deux bornes dans laquelle l'information magnétique est écrite par l'application d'un champ électrique appliqué à travers l'élément ferroélectrique (10).

10. Utilisation d'au moins un dispositif selon la revendication 7 dans un système adapté pour l'enregistrement magnétique.

## Patentansprüche

1. Vorrichtung umfassend:
- eine Anordnung (2), die aus zwei dünnen Schichten, jeweils einer oberen (6) und unteren (4), gebildet ist, die jeweils ein ferromagnetisches Element bilden und durch eine dünne Schicht (8), die ein nichtmagnetisches Element bildet, getrennt sind, wobei die Anordnung derart aufgebaut ist, dass die die ferromagnetischen Elemente (4, 6) bildenden Schichten durch die ein nichtmagnetisches Element (8) bildenden Schicht hindurch magnetisch gekoppelt sind;
- eine Elektrode (12),
- eine ein ferroelektrisches Element (10) bildende Schicht, in dem die Polarisation durch Anlegen einer elektrischen Spannung durch die Schicht gemäß mehreren Richtungen ausgerichtet werden kann, wobei die ein ferroelektrisches Element (10) bildende Schicht zwischen der ein unteres ferromagnetisches Element (4) bildenden Schicht und der Elektrode (12) angeordnet ist;
wobei eine Dicke der dünnen Schicht (8), die ein nichtmagnetisches Element bildet, derart gewählt ist, dass die Schichten, die die ferromagnetischen Elemente (4, 6) bilden, über die Ruderman-Kittel-Kasuya-Yosida, RKKY, Wechselwirkung magnetisch gekoppelt sind;
wobei die Vorrichtung ausgebildet ist, eine Steuerung der magnetischen Konfiguration der die ferromagnetischen Elemente (4, 6) bildenden Schichten durch die Richtung der Polarisation in der das ferroelektrische Element (10) bildenden Schicht ermöglicht, wobei die Richtung der Polarisation der das ferroelektrische Element (10) bildenden Schicht die magnetische Konfiguration der die ferromagnetischen Elemente (4, 6) bildenden Schichten durch Steuerung der Periode und/oder Phase der RKKY Wechselwirkung steuert;
wobei die Schichten, die die ferromagnetischen Elemente (4, 6) bilden, entweder ferromagnetisch oder antiferromagnetisch gekoppelt sind.

2. Vorrichtung nach Anspruch 1, **dadurch gekennzeichnet, dass** die ein nichtmagnetisches Element (8) bildende Schicht eine Dicke zwischen 0,2 und 10 nm aufweist.

3. Vorrichtung nach Anspruch 1 oder 2, **dadurch gekennzeichnet, dass** die ein ferroelektrisches Element (10) bildende Schicht eine Dicke zwischen 0,2 und 500 nm aufweist.

4. Vorrichtung nach einem der Ansprüche 1 bis 3, **dadurch gekennzeichnet, dass** sie ein System umfasst, das die Festlegung der Magnetisierung eines der ferromagnetischen Elemente der Vorrichtung ermöglicht.

5. Vorrichtung nach Anspruch 4, **dadurch gekennzeichnet, dass** das System aus einer Schicht (28, 30) gebildet ist, die aus einem antiferromagnetischen Material gestaltet ist.

6. Vorrichtung nach Anspruch 4 oder 5, bei der:
- die Elektrode (12) aus einem ferromagnetischen Material (24) gebildet ist;
- wobei die ein ferroelektrisches Element (10) bildende Schicht angepasst ist, einen Tunnelstrom zwischen der ferromagnetischen Elektrode (24) und der ein unteres ferromagnetisches Element (4) bildende Schicht durchzulassen, wobei diese Schicht vorzugsweise eine Dicke zwischen 0,2 und 10 nm aufweist;
- das System, das eine Festlegung der Magnetisierung eines der ferromagnetischen Elemente ermöglicht, angepasst ist, die Magnetisierung der ein oberes ferromagnetisches Element (6) bildenden Schicht und die der ferromagnetischen Elektrode (24) festzulegen.

7. Vorrichtung nach einem beliebigen der Ansprüche 1 bis 3, **dadurch gekennzeichnet, dass** die ein nichtmagnetische Element (8) bildende Schicht leitend ist, wobei die Vorrichtung angepasst ist, ein dipolares Magnetfeld in Abhängigkeit von der magnetischen Konfiguration der das untere (4) und obere (6) ferromagnetische Element bildenden Schicht zu erzeugen und das in Form von Linien oder Arrays kombinierbar ist, um die Erzeugung und elektrische Steuerung einer Magnetfeldlandschaft zu ermöglichen.

8. Verwendung einer Vorrichtung nach einem beliebigen der Ansprüche 1 bis 5 in einem magnetischen Speicher mit drei Anschlüssen, in den die magnetische Information durch Anlegen eines elektrischen Feldes, das durch das ferroelektrische Element (10) hindurch aufgebracht wird, eingeschrieben wird.

9. Verwendung einer Vorrichtung nach Anspruch 6 in einem magnetischen Speicher mit zwei Anschlüssen, in den die magnetische Information durch Anlegen eines elektrischen Feldes, das durch das ferroelektrische Element (10) hindurch aufgebracht wird, eingeschrieben wird.

10. Verwendung mindestens einer Vorrichtung nach Anspruch 7 in einem für die magnetische Aufzeichnung angepassten System.

## Claims

1. A device comprising:
- an assembly (2) consisting of two thin respectively upper (6) and lower (4) layers, each forming a ferromagnetic element and separated from one another by a thin layer (8) forming a non-magnetic element, said assembly being made up so that the layers forming the ferromagnetic elements (4, 6) are magnetically coupled through the layer forming a non-magnetic element (8);
- an electrode (12),
- a layer forming a ferroelectric element (10) in which the polarization may be oriented in several directions by applying an electric voltage through said layer, said layer forming a ferroelectric element (10) being positioned between the layer forming a lower ferromagnetic element (4) and the electrode (12);
a thickness of the thin layer (8) forming a non-magnetic element being selected so that both ferromagnetic layers 4, 6 are magnetically coupled via the Ruderman-Kittel-Kasuya-Yosida interaction, (RKKY);
said device being configured so as to allow control of the magnetic configuration of the layers forming ferromagnetic elements (4, 6) by the direction of the polarization in the layer forming a ferroelectric element (10), the direction of polarization in the layer forming ferroelectric element (10) controlling the magnetic configuration of both layers forming ferromagnetic elements (4, 6) by controlling the period and/or the phase of the RKKY interaction;
the layers forming ferromagnetic elements (4, 6) being coupled either in a ferromagnetic manner or in an antiferromagnetic manner.

2. The device according to claim 1, **characterized in that** the layer forming a non-magnetic element (8) has a thickness comprised between 0.2 and 10 nm.

3. The device according to claim 1 or 2, **characterized in that** the layer forming a ferroelectric element (10) has a thickness comprised between 0.2 and 500 nm.

4. The device according to any of claims 1 to 3, **characterized in that** it comprises a system giving the possibility of setting the magnetization of a ferromagnetic material.

5. The device according to claim 4, **characterized in that** said system consists of a layer of small thickness (28, 30) formed with an antiferromagnetic material.

6. The device according to claim 4 or 5, wherein:
- the electrode (12) is formed with a ferromagnetic material (24);
- the layer forming a ferroelectric element (10) is adapted to let through a tunnel current between the ferromagnetic electrode (24) and the lower layer forming ferromagnetic element (4), said layer preferably having a thickness comprised between 0.2 and 10 nm;
- said system with which the magnetization of a ferromagnetic material may be set, is adapted for setting the magnetization of the upper layer forming a ferromagnetic element (6) and that of the ferromagnetic electrode (24).

7. The device according to any of the claims 1 to 3, **characterized in that** the layer forming a non-magnetic element (8) is conductive, said device being adapted so as to generate a dipolar magnetic field which depends on the magnetic configuration of the layers forming lower (4) and upper (6) ferromagnetic elements and which may be combined in the form of lines or networks for allowing generation and electric control of a magnetic field landscape.

8. The use of a device according to any of claims 1 to 5, in a three-terminal magnetic memory in which the magnetic information is written by applying an electric field applied through the ferroelectric element (10).

9. The use of a device according to claim 6 in a two-terminal magnetic memory, in which the magnetic information is written by applying an electric field applied through the ferroelectric element (10).

10. The use of at least one device according to claim 7 in a system adapted for magnetic recording.
